# EUROPÄISCHE PATENTANMELDUNG

(11) **EP 4 600 187 A1**
(43) Veröffentlichungstag der Anmeldung: **13.08.2025**
(21) Anmeldenummer: 25155722.9
(22) Anmeldetag: 04.02.2025
(51) Int. Cl.: B65G 47/84, B08B 9/08, B08B 9/30, B08B 9/44, B29C 49/42, C23C 14/50, B08B 9/42

(54) **BEHÄLTERBEHANDLUNGSANLAGE ZUM BEHANDELN VON BEHÄLTERN**

(30) Priorität: 07.02.2024 DE 102024103388
(71) Anmelder: KHS GmbH, 44143 Dortmund (DE)
(72) Erfinder: Langhammer, Philipp, 44143 Dortmund (DE); Schetle, Andreas, 44143 Dortmund (DE)
(74) Vertreter: Andrejewski - Honke Patent- und Rechtsanwälte Partnerschaft mbB

(57) **Zusammenfassung**

Die Erfindung betrifft ein Behälterbehandlungsanlage zum Behandeln von Behältern (3), insbesondere von Getränkebehältern, mit zumindest einer auf einem rotierbaren Träger (1) angeordneten Behälterführung (2), welche gegenüber einem Fluidauslass (4) einer Behandlungseinheit (3) hubbeweglich verstellbar ausgebildet ist und wobei der Behälterführung (2) zumindest ein Federelement (9) zugeordnet ist, welches für eine hubbewegliche Rückstellung zwischen einer Behandlungsposition und einer Losposition eingerichtet ist. Erfindungsgemäß ist zur Ausbildung einer Nothubeinrichtung (10) zumindest eine Stellkurve (12a, 12b) in einem Endabschnitt an dem rotierbaren Träger (1) angeordnet und kann für die hubbewegliche Rückstellung mit der Behälterführung (2) zusammenzuwirkend in Eingriff gebracht werden.

## Beschreibung

Die Erfindung betrifft eine Behälterbehandlungsanlage zum Behandeln von Behältern, insbesondere von Getränkebehältern, mit zumindest einer auf einem rotierbaren Träger angeordneten Behälterführung, welche gegenüber einem Fluidauslass einer Behandlungseinheit hubbeweglich verstellbar ausgebildet ist und wobei der Behälterführung zumindest ein Federelement zugeordnet ist, welches für eine hubbewegliche Rückstellung zwischen einer Behandlungsposition und einer Losposition eingerichtet ist. Unter einer Losposition ist in diesem Zusammenhang eine Stellung der Behälterführung gemeint, in der der Behälter in die Behälterführung eingeführt oder aus dieser wieder entnommen werden kann. Im Gegensatz dazu betrifft die Behandlungsposition eine Stellung der Behälterführung, in der eine Behandlung der Behälter erfolgt.

Mit einer Behandlung der Behälter sind im Rahmen der Erfindung grundsätzlich sämtliche Tätigkeiten zu verstehen, welche den Behälter oder ein in den Behälter angeordnetes Füllgut physisch oder optisch beeinflussen. Besonders bevorzugt betrifft die Erfindung Behälterbehandlungsanlagen, welche dazu vorgesehen sind, die Behälter innenliegend zu beschichten. Entsprechend sind die Behälterbehandlungsanlagen dann als Behälterbeschichtungsanlagen ausgebildet. Bei den Behältern kann es sich aber auch um bereits beschichtete Behälter, insbesondere Flaschen, handeln. Bevorzugt handelt es sich um mittels Plasmabeschichtung beschichtete Behälter. Die Behälter bestehen vorzugsweise aus PET.

Unabhängig von der Ausbildung der Behälterbehandlungsanlage werden die Behälter in die Behälterführung eingesetzt und durch eine hubbewegliche Verstellung in die Behandlungsposition überführt. Nach dieser Behandlung müssen die Behälter sodann wieder zurück in die Losposition überführt werden, um eine Entnahme des Behälters und entsprechend das Einsetzen eines weiteren Behälters zu ermöglichen. Dieses Prinzip hat sich grundsätzlich bewährt, da insbesondere die hubbewegliche Rückstellung über das Federelement einen zuverlässigen Betrieb ermöglicht und die Geschwindigkeit der Rückstellung allein auf Basis der Federkonstanten des Federelementes ausgewählt werden kann. Hierbei ist das Federelement so ausgelegt, dass einerseits eine rechtzeitige Rückstellung ermöglicht wird. Andererseits wird das Federelement auch einer Anpresskraft entgegen, mit welcher die Behälter gegen den Fluidauslass gedrückt werden, um eine ausreichende Dichtungswirkung zu erzielen. Entsprechend ist die Auswahl der Federelemente anhand gegenläufiger Anforderungen zu treffen.

Wenngleich sich dieses Prinzip bislang bewährt hat, so ist zukünftig vorgesehen, höhere Durchsätze von Behältern in den Behälterbehandlungsanlagen zu ermöglichen. Um eine aufwändige Umkonstruktion der Behälterbehandlungsanlage zu vermeiden, kann beispielsweise ein höherer Behälterdurchsatz dadurch ermöglicht werden, dass der rotierbare Träger mit einer größeren Drehzahl betrieben wird als bislang vorgesehen. Neben einer kürzeren Behandlungszeit ist dann auch die hubbewegliche Rückstellung der Behälterführungen sehr viel schneller durchzuführen als dies bislang der Fall war. Dies hat zur Folge, dass unter gewissen Umständen das Federelement nicht rechtzeitig eine Überführung zwischen der Behandlungsposition und der Losposition bewirken kann. Dies kann insbesondere dann der Fall sein, wenn das Federelement bereits über einen längeren Zeitraum im Einsatz war und entsprechend Verschleißerscheinungen unterliegt.

Eine nicht rechtzeitige Überführung in die Losposition hat jedoch zur Folge, dass der Behälter nicht oder zumindest nicht rechtzeitig aus der Behälterführung entnommen werden kann und somit der Einsatz eines weiteren Behälters verhindert wird. Dies hat unweigerlich zur Folge, dass der Betrieb der Behälterbehandlungsanlage unterbrochen werden muss. Auch Schäden an den Behältern sowie an der Behälterbehandlungsanlage können die Folge sein. Entsprechend ist bei höheren Drehzahlen stets sicherzustellen, dass auch bei einem nicht ordnungsgemäßen Betrieb der Federelemente eine Rückführung in die Losposition gewährleistet wird.

Lösung dieser Aufgabe und Gegenstand der Erfindung ist daher eine Behälterbehandlungsanlage gemäß Patentanspruch 1. Demnach ist erfindungsgemäß vorgesehen, dass zur Ausbildung einer Nothubeinrichtung zumindest eine Stellkurve in einem Endabschnitt an dem rotierbaren Träger angeordnet ist und für die hubbewegliche Rückstellung mit der Behälterführung zusammenwirkend in Eingriff gebracht werden kann.

Die Nothubeinrichtung ist entsprechend in bekannter Art und Weise als Kurvensteuerung ausgebildet, bei der die Stellkurve stationär neben dem rotierbaren Träger angeordnet ist. Mit einer Stellkurve ist in diesem Zusammenhang ein Bauteil gemeint, welches in dem Endabschnitt angeordnet ist und welche ein in vertikaler Richtung verlaufenes Höhenprofil aufweist. Über dieses Höhenprofil ist es möglich, dass im Falle eines Eingreifens der Behälterführung an der Stellkurve eine Bewegung der Behälterführung in vertikaler Richtung bewirkt wird. Da die Stellkurve die vertikale Position der Behälterführung zwingendermaßen festlegt, wird somit sichergestellt, dass im Falle einer nicht ordnungsgemäßen Funktion des Federelements zumindest über die Stellkurve eine hubbewegliche Rückstellung der Behälterführung von der Behandlungsposition in die Losposition bewirkt wird. In diesem Zusammenhang ist auch anzumerken, dass die Stellkurve lediglich dann mit der Behälterführung in Eingriff gebracht wird, wenn das Federelement keine rechtzeitige Rückstellung ermöglicht. Insofern wird bei einem ordnungsgemäßen Betrieb der Behälterbehandlungsanlage von der Nothubeinrichtung kein Gebrauch gemacht. Es stellt lediglich ein Zusatzelement dar, über das in redundanter Art und Weise sichergestellt werden soll, dass die Losposition in dem Endabschnitt zwingend erreicht wird.

Gemäß einer bevorzugten Ausgestaltung der Erfindung weist die Behälterführung zumindest einen vorstehenden Stellabschnitt auf, welcher in dem Endabschnitt mit der zumindest einen Stellkurve in Eingriff gebracht werden kann. Entsprechend bildet der Stellabschnitt den Bereich der Behälterführung, welcher mit der Stellkurve zusammenwirken kann. Mit einem vorstehenden Stellabschnitt ist in diesem Zusammenhang gemeint, dass der zumindest eine Stellabschnitt gegenüber den nicht als Stellabschnitt vorgesehenen Abschnitten der Behälterführung in einer Richtung vorsteht. Hieraus ergeben sich unterschiedliche Anordnungsmöglichkeiten, wobei insbesondere ein radial nach außen oder innen vorstehender Stellabschnitt vorgesehen sind kann. Entsprechend ist bei einem radial nach innen vorstehenden Stellabschnitt die zumindest eine Stellkurve innenliegend und bei einem radial nach außen vorstehenden Stellabschnitt die zumindest eine Stellkurve außenliegend von der Behälterführung angeordnet.

Eine bevorzugte Weiterbildung der Erfindung sieht vor, dass die Behälterführung als Greifer mit zwei Greiferarmen ausgebildet ist, wobei die Greifarme zumindest abschnittsweise zueinander verschwenkbar sind. Die Greifarme sind hierbei vorzugsweise zu ausgebildet, dass ein Greifarm in Transportrichtung vor und der andere Greifarm in Transportrichtung hinter dem Behälter angeordnet ist. Grundsätzlich können die Greifarme auch eine Konturierung aufweisen, so dass diese beispielsweise im Haltezustand eine runde Aufnahme bilden, in der der Behälter anliegt. Darüber hinaus kann über die verschwenkbaren Abschnitte eine Anpresskraft auf die Behälter ausgeübt werden, um diese klemmend bzw. kraftschlüssig zu halten. Diese verschwenkbaren Abschnitte sind bevorzugt federbelastet.

Darüber hinaus sind die Greifarme üblicherweise derart angeordnet, dass sie unabhängig von der Orientierung des Behälters im Bereich der Behältermündung die Behälter greifen. Eine solche Ausgestaltung kann insbesondere dann sinnvoll sein, wenn die Behälter als Getränkeflaschen, insbesondere als Getränkeflaschen aus Kunststoff, z.B. Polyethylenterephthalat (PET), ausgebildet sind. In einem solchen Fall weisen die Getränkeflaschen üblicherweise einen sogenannten Neckring auf, welcher gegenüber einem Außengewinde, welches der Aufnahme einer Verschlusskappe dient, vorsteht. Die Greifarme sind dann bevorzugt so angeordnet, dass diese die Getränkeflasche auf einer der Behältermündung abgewandten Seite des Neckringes greifen. Bei einer Getränkeflasche mit nach oben ausgerichteter Behältermündung greift dann der Greifer die Getränkeflasche unterhalb des Neckrings. Bei einer Anordnung der Getränkeflasche kopfüber ist der Greifer oberhalb des Neckrings angeordnet.

Ausgehend von einer solchen Ausgestaltung sieht die Erfindung verschiedene Anordnungsmöglichkeiten für den Stellabschnitt bzw. für die Stellabschnitte vor, wobei gemäß einer ersten Ausgestaltung der zumindest eine Stellabschnitt an einem der Greifarme angeordnet ist. Dieser kann dann in dem Endabschnitt mit der zumindest einen Stellkurve zusammenwirkend in Eingriff gebracht werden kann, welche radial außenliegend von der Behälterführung angeordnet ist. Entsprechend wird die Funktion der Nothubeinrichtung über zumindest einen Greiferarm und der damit zusammenwirkenden Stellkurve ermöglicht. Hierbei reicht es grundsätzlich aus, wenn lediglich einer der Greifarme einen entsprechenden Stellabschnitt aufweist, da die beiden Greiferarme bezüglich einer Hubbewegung mechanisch miteinander gekoppelt sind. Um dennoch eine gleichmäßige Kraftbelastung zu ermöglichen, kann es zweckmäßig sein, wenn beide Greifarme einen entsprechenden vorstehenden Stellabschnitt aufweisen, um ein Verkanten der Behälterführung zu vermeiden. Eine solche Ausgestaltung bietet jedoch den Vorteil, dass die Stellkurven radial außenliegend vom Träger angeordnet werden können, wobei in diesem Bereich üblicherweise ausreichend Bauraum zur Verfügung steht.

Ausgehend von einer solchen Ausgestaltung ist bevorzugt vorgesehen, dass die Endabschnitte der beiden Greiferarme vorzugsweise mit unterschiedlichen Stellkurven zusammenwirkend in Eingriff gebracht werden können. Hierdurch soll gewährleistet werden, dass die beiden Greiferarme zur gleichen Zeit an der gleichen Position eine identische Hubbewegung erfahren. Entsprechend sind nunmehr zwei separate Stellkurven vorgesehen, welche ein in Transportrichtung zueinander versetztes Höhenprofil aufweisen. Mit der Transportrichtung ist hierbei die Bewegung der Behälter gemeint, wobei die Transportrichtung sich insbesondere in der Drehbewegung des Trägers widerspiegelt. Hierbei ist zu beachten, dass die beiden Greiferarme und damit auch die beiden Stellabschnitt bezüglich einer Drehbewegung hintereinander angeordnet sind, sodass deren Versatz in Transportrichtung bzw. Umfangsrichtung sich in einem Versatz der Höhenprofile widerspiegeln muss.

Besonders bevorzugt ist vorgesehen, dass die Stellkurven in Transportrichtung und in einer radialen Richtung hintereinander angeordnet sind. Demnach wird vorgesehen, dass neben einem Versatz in Transportrichtung nunmehr auch ein radialer Versatz vorgesehen ist, sodass entsprechend die beiden Stellkurven in radialer Richtung hintereinander angeordnet werden können. Hierbei bezieht sich die radiale Richtung auf den Träger. Ausgehend von einer solchen Ausgestaltung kann dann eine erste Stellkurve in Transportrichtung vor der zweiten Stellkurve angeordnet sein. Darüber hinaus kann die erste Stellkurve in radialer Richtung außenliegend gegenüber der zweiten Stellkurve angeordnet sein.

Eine bevorzugte Weiterbildung sieht vor, dass die Stellkurven und auch die Stellabschnitte jeweils zueinander einen Versatz in vertikaler Richtung aufweisen. Hierdurch soll gewährleistet werden, dass die Zuordnung der Stellabschnitt zu den einzelnen Stellkurven stets gewährleistet wird, sodass die einzelnen Stellabschnitte lediglich mit jeweils einer Stellkurve zusammenwirken. Entsprechend kann der erste Greiferarm einen ersten Stellabschnitt aufweisen, welcher mit einer ersten Stellkurve zusammenwirkt und der zweite Greiferarm einen zweiten Stellabschnitt aufweisen, welche mit der zweiten Stellkurve zusammenwirken kann.

Eine alternative Ausgestaltung sieht vor, dass die Stellkurve radial innenliegend von der Behälterführung angeordnet ist und wobei der zumindest eine Stellabschnitt an einer der Greifarme gegenüberliegenden Seite der Behälterführung angeordnet ist. Insbesondere ist der Stellabschnitt an einem nicht-verschwenkbaren Abschnitt der Behälterführung angeordnet. Eine solche Ausgestaltung ermöglicht es, dass der Stellabschnitt möglichst zentriert an der Behälterführung angeordnet ist, so dass während eines Hubes keine bzw. nur unwesentliche Hebelkräfte auf die Behälterführung einwirken, so dass entsprechend mit nur einem Stellabschnitt ein Verkippen bzw. Verkanten vermieden werden kann. Insofern sieht eine solche Ausgestaltung bevorzugt ausschließlich einen Stellabschnitt und entsprechend ausschließlich eine Stellkurve vor.

Eine Weiterbildung der erfindungsgemäßen Behälterbehandlungsanlage sieht vor, dass die Stellabschnitte jeweils integral mit der Behälterführung, insbesondere mit einem Greifabschnitt der Greiferarme, ausgebildet sind. Insofern handelt es sich dann bei den Stellabschnitten um feststehende Elemente, welche im Gegensatz zu üblichen Kurvensteuerungen nicht an den Steuerkurven abrollen. Hierbei wird in Kauf genommen, dass sich eine etwas größere Reibung zwischen den Stellabschnitten und den Kurvensteuerungen ergibt. Allerdings ist zu beachten, dass es sich lediglich um eine Nothubeinrichtung handelt, welche nur für kurze Einsätze vorgesehen ist und damit nicht den Regelbetrieb abbildet. Darüber hinaus können, je nach Ausgestaltung der Behälterbehandlungsanlage, gummierte Rollen im Bereich der Greiferarme problematisch sein, da bei einem Abrieb von diesen Gummirollen Rückstände in die Behälter gelangen könnten.

Um dennoch die Reibung möglichst gering zu halten, sieht eine bevorzugte Ausgestaltung vor, dass die Stellabschnitte auf einer der jeweiligen Stellkurve zugeordneten Seite eine abgerundete Anlagefläche aufweisen. Entsprechend berührt der Stellabschnitt die Stellkurve nur über eine vergleichsweise geringe Anlagefläche, sodass die Reibung zwischen diesen beiden Elementen reduziert wird.

Gemäß einer bevorzugten Weiterbildung der Erfindung ist vorgesehen, dass die Stellkurve eine Länge in Transportrichtung zwischen 70 und 150 mm aufweist, wobei sich diese Länge ausschließlich auf den Bereich der Stellkurve bezieht, in dem in vertikale Änderung bewirkt wird. Darüber hinaus ist die Stellkurve so ausgebildet, dass das Höhenprofil der Stellkurve eine Hubbewegung zwischen 5 mm und 20 mm ermöglicht. Entsprechend ist auch die generell vorgesehene hubbewegliche Rückstellung zwischen der Behandlungsposition und der Losposition entlang einer Länge zwischen 5 mm und 20 m ausgebildet.

Eine bevorzugte Weiterbildung der Erfindung sieht vor, dass eine Detektionseinrichtung vorgesehen und dazu eingerichtet ist, ein Kontakt zwischen der Stellkurve und zumindest einem Stellabschnitt zu detektieren. Hierbei kann es sich beispielsweise um eine elektrische Kontaktierung oder aber auch um eine Lichtschrankendetektion handeln. Anhand der Detektionseinrichtung kann die Häufigkeit des Einsatzes der Nothubeinrichtung ermittelt werden. Dies kann für den Anwender ein Hinweis darauf geben, ob ein Austausch oder eine Verstellung des Federelementes oder mehrerer Federelemente notwendig ist.

Bevorzugt ist die Behandlungseinheit als Beschichtungseinheit ausgebildet. Entsprechend handelt es sich bei der Behälterbehandlungsanlage um eine Behälterbeschichtungsanlage, wobei üblicherweise als Getränkeflaschen ausgebildete Behälter beschichtet werden.

Derartige Behälterbeschichtungsanlagen sind grundsätzlich aus dem Stand der Technik bekannt und dienen dazu, Behälter mit einer Innenbeschichtung zu versehen. Die Erfindung bezieht sich insbesondere auf Behälter aus dem Bereich der Lebensmitteltechnik, insbesondere der Getränketechnik. Entsprechend handelt es sich bei den Behältern um Getränkebehälter, beispielsweise um Getränkeflaschen. Die Getränkebehälter bestehen insbesondere aus Kunststoff z.B. aus Polyethylenterephthalat (PET) und werden vor der Beschichtung üblicherweise im Rahmen einer Blasumformung aus Vorformlingen ausgeformt.

Da insbesondere Polyethylenterephthalat nur geringe Barriereeigenschaften gegen das Eindringen von Sauerstoff und/oder das Austreten von Kohlendioxid oder anderen Gasen aufweist, kann mithilfe einer entsprechenden Beschichtungsanlage eine zusätzliche Barriereschicht innenliegend auf die Behälterwandungen aufgebracht werden.

Eine solche Beschichtung erfolgt üblicherweise mithilfe sogenannter Plasmabeschichtungsverfahren, wobei aus einem Plasma heraus die entsprechenden Schichten abgeschieden werden und sich auf den Wandungen des Getränkebehälters absetzen. In diesem Zusammenhang ist auch von sogenannten PCVD-Verfahren ("Plasma Chemical Vapor Deposition") oder PICVD-Verfahren ("Plasma Impuls Chemical Vapor Deposition") die Rede, wobei insbesondere Schichten aus Siliziumoxid abgeschieden werden. Entsprechende Verfahren sind zum Beispiel aus der WO 03/100125 A1 und aus der WO 03/100121 A2 bekannt.

Die Beschichtung der Behälter erfolgt in einem Beschichtungsrad, welches aus dem rotierbaren Träger sowie einer oder mehrerer Beschichtungseinheiten gebildet ist. Während der Beschichtung werden die Behälter innerhalb der Behälterführungen zunächst evakuiert und sodann nach Einbringen verschiedener Gase über die Beschichtungseinheit die entsprechende Barriereschicht aus dem Plasma abgeschieden.

Eine besonders bevorzugte Weiterbildung der Erfindung sieht ferner vor, dass die Behälterführung oberhalb des Fluidauslasses angeordnet ist. Eine solche Ausgestaltung ist insbesondere dann sinnvoll, wenn die Behälterbehandlungsanlage als Behälterbeschichtungsanlage ausgebildet ist. Entsprechend werden die Behälter kopfüber in die Behälterführung eingesetzt, sodass dann über den Fluidauslass das entsprechende Fluid in die Behälter eingeführt wird, wobei es sich bei dem Fluid im Falle einer Behälterbeschichtungsanlage um Gase handelt. Die Nothubeinrichtung und entsprechend auch das Federelement sind dann so eingerichtet, dass eine hubbewegliche Rückstellung eine Bewegung der Behälter nach oben hin in vertikaler Richtung ermöglicht wird. Entsprechend wird dann gegen die Schwerkraft der Behälter und auch der Behälterführungen gearbeitet.

Eine Weiterbildung der Erfindung sieht ferner vor, dass eine Vielzahl von in Umfangsrichtung identisch ausgebildeten Behälterführungen vorgesehen sind bzw. an dem rotierbaren Träger angeordnet sind und welche zumindest einer gemeinsamen Stellkurve zugeordnet sind. Selbstverständlich kann hierbei auch vorgesehen sein, dass gerade bei einer Ausgestaltung mit Greifarmen jeweils die ersten Greifarme einer Vielzahl von Behälterführungen einer gemeinsamen ersten Stellkurve und die zweiten Greifarme einer Vielzahl von Behälterführungen einer gemeinsamen zweiten Stellkurve zugeordnet sind.

Im Folgenden wird die Erfindung anhand eines Ausführungsbeispiels näher erläutert. Es zeigen:
Fig. 1 eine Behälterbehandlungsanlage zum Beschichten von Behältern in einer isometrischen Darstellung
Fig. 2 die Behälterbehandlungsanlage gemäß Fig.1 im Bereich der Behälterführung,
Fig. 3a, 3b die Behälterführung mit Darstellung des Federelements sowohl in einer Losposition als auch einer Verhandlungsposition,
Fig. 4 die Behälterbehandlungsanlage mit dargestellter Nothubeinrichtung mit innenliegender Stellkurve
Fig. 5 die Behälterbehandlungsanlage mit alternativer Nothubeinrichtung mit außenliegender Stellkurve.

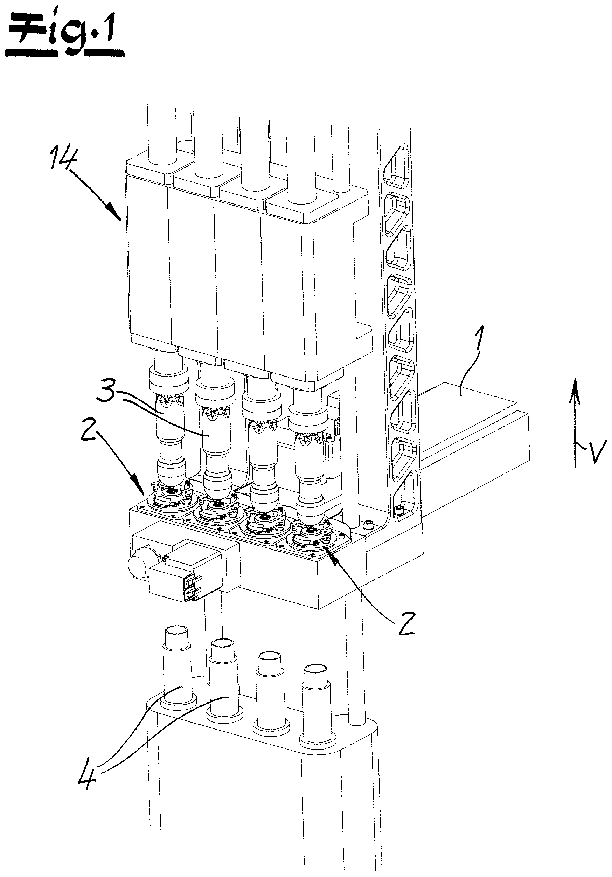

Die Fig. 1 zeigt einen isometrischen Ausschnitt aus einer als Behälterbeschichtungsanlage ausgebildeten Behälterbehandlungsanlage. Diese Behälterbehandlungsanlage weist einen rotierbaren Träger 1 mit daran angeordneten Behälterführungen 2 auf, wobei im Falle der dargestellten Behälterbeschichtungsanlage immer vier Behälterführungen 2 zusammengefasst sind. Darüber hinaus ist auch eine Behandlungseinheit 14 vorgesehen, welche in diesem Fall als Beschichtungseinheit ausgebildet und dazu eingerichtet ist, nach dem Einsetzen der als Getränkeflaschen ausgebildeten Behälter 3 über diese gefahren zu werden. In vertikaler Richtung V unterhalb der Behälterführungen 2 sind darüber hinaus eine Vielzahl von Fluidauslässen 4 vorgesehen, welche ebenfalls in vertikaler Richtung V verfahren werden und welche über die Behälterführungen 2 eine Zuführung von Gasen in abgedichteter Art und Weise in die Behälter 3 ermöglichen.

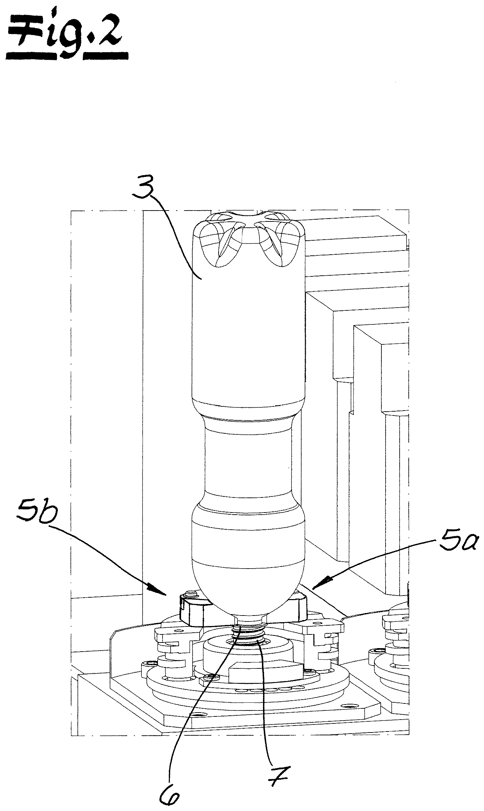

Die Behälterführungen 2 sind als Greifer ausgebildet, welche in der Fig. 2 näher dargestellt sind.

Der als Getränkeflasche ausgebildete Behälter 3 wird kopfüber in die Behälterführungen eingesetzt und jeweils über zwei Greifarme 5a, 5b gehalten. Die Greifarme sind hierbei so eingerichtet, dass sie oberhalb eines Neckringes 6 angeordnet sind. Dieser Neckring 6 ist Teil des Behälters 3 und steht gegenüber einem Außengewinde 7 vor, welches der Aufnahme einer Verschlusskappe dient.

Um die zuvor erwähnte Abdichtung zwischen dem Fluidauslass 4 und einer Flaschenmündung 8 zu ermöglichen, wird der Behälter 3 zwischen einer in der

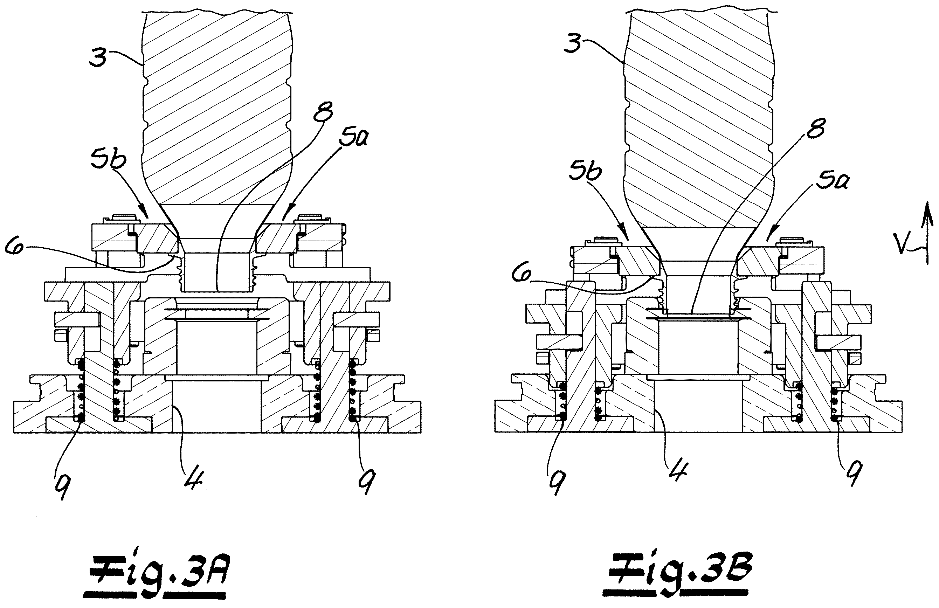

Fig. 3a dargestellten Losposition und einer in der Fig. 3b dargestellten Behandlungsposition hubbeweglich entgegen der vertikalen Richtung V verfahren. Hierdurch wird die Behältermündung 8 bzw. die die Behältermündung 8 umgebende Wandung gegen den Fluidauslass 4 gedrückt, sodass in einfacher Art und Weise das Gas in die Behälter 3 eingefüllt werden kann. Die hubbewegliche Verstellung erfolgt über die Greifarme 5a, 5b, welche oberhalb des Neckringes 6 angeordnet sind und somit dem Behälter 3 nach unten drücken können.

Zugleich werden Federelemente 9 zusammengedrückt, welche der hubbeweglichen Rückstellung von der Behandlungsposition in die Losposition dienen. Sofern also die Greifarme 5a, 5b keine Verstellkraft erfahren, drücken die Federelemente 9 die Behälterführung 2 nach oben.

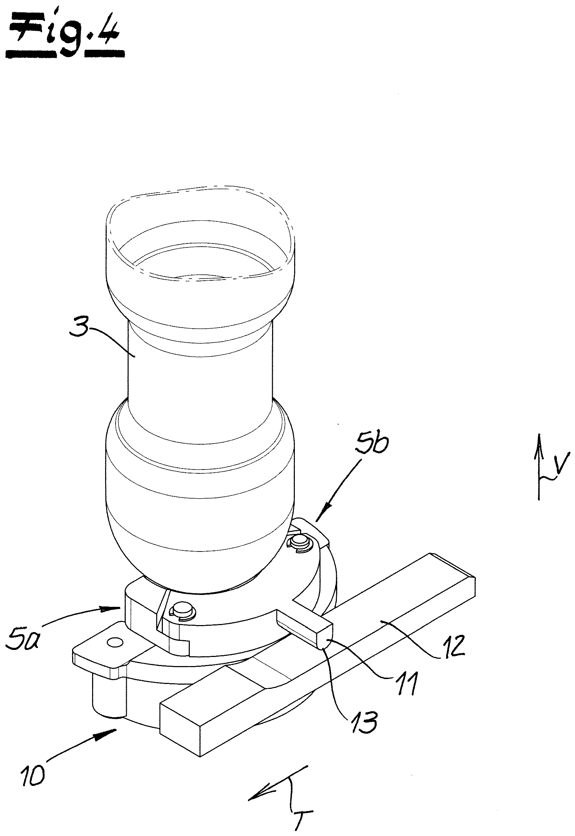

Da jedoch die hubbewegliche Rückstellung mithilfe der Federelemente 9 einer gewissen Trägheit unterliegt, ist es nicht möglich, die Drehgeschwindigkeit ohne weiteres zu erhöhen, während zugleich die hubbewegliche Rückstellung zwischen der Behandlungsposition und der Losposition in einem festgelegten Zeitintervall funktionieren soll. Zumindest ist nicht auszuschließen, dass die Federelemente 9 eine solche hubbewegliche Rückstellung rechtzeitig bewirken, sodass entsprechend die Fig. 4 eine ergänzende Nothubeinrichtung 10 zeigt.

Hierbei weist die Behälterführung 2 an einem hinteren Abschnitt einen Stellabschnitt 11 auf, welcher mit einer radial innenliegenden Stellkurve 12 zusammenwirken kann, sofern die Federelemente 9 keine rechtzeitige hubbewegliche Rückstellung bewirken.

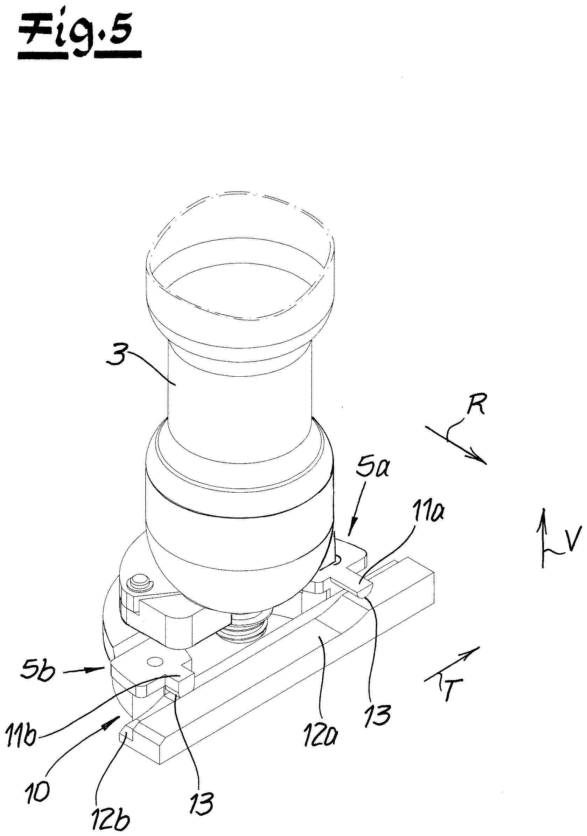

Eine alternative Ausgestaltung ist in der Fig. 5 gezeigt, wobei der erste Greifarm 5a einen vorstehenden ersten Stellabschnitt 11a und der zweite Greifarme 5b einen vorstehenden Stellabschnitt 11b auf, wobei der erste Stellabschnitt 11a mit einer ersten Stellkurve 12a und der zweite Stellabschnitt mit einer zweiten Stellkurve 12b zusammenwirken kann und wobei die Stellkurven 12a, 12b radial außenliegend von der Behälterführung 2 angeordnet sind. Die beiden Stellkurve 12a, 12b sind sowohl in Transportrichtung T als auch in radialer Richtung R versetzt zueinander angeordnet, wobei die erste Stellkurve 12a radial außenliegend von der zweiten Stellkurve 12b angeordnet ist. Der Versatz in Transportrichtung T ermöglicht, dass beide Stellabschnitte 11a, 11b und damit auch beide Greifarme 5a, 5b gleichzeitig eine Bewegung in vertikaler Richtung V erfahren.

Unabhängig von der konkreten Ausgestaltung weisen die Stellkurven 12, 12a, 12b jeweils ein Höhenprofil auf, wobei durch das Höhenprofil ein Versatz in vertikaler Richtung V zwischen 5 und 20 mm ermöglicht wird. Dies entspricht exakt dem Weg, welche ohnehin durch die Federelemente 9 im Zuge der hubbeweglichen Rückstellung bewirkt werden soll.

Die Stellabschnitte 11, 11a, 11b sind integral mit Abschnitten der Behälterführung 2, insbesondere mit den Greifarmen 5a, 5b ausgebildet, und weisen eine abgerundete Anlagefläche 13 auf, um die Reibung zwischen den Stellabschnitten 11, 11a, 11b und den Stellkurven 12, 12a, 12b zu miniminieren.

### Bezugszeichenliste

- 1: rotierbarer Träger
- 2: Behälterführung
- 3: Behälter
- 4: Fluidauslass
- 5a ,5b: Greifarme
- 6: Neckring
- 7: Außengewinde
- 8: Flaschenmündung
- 9: Federelement
- 10: Nothubeinrichtung
- 11, 11a, 11b: Stellabschnitte
- 12, 12a, 12b: Stellkurven
- 13: Anlagefläche
- 14: Behandlungseinheit
- R: radiale Richtung
- T: Transportrichtung
- V: vertikale Richtung

## Patentansprüche

1. Behälterbehandlungsanlage zum Behandeln von Behältern (3), insbesondere von Getränkebehältern, mit zumindest einer auf einem rotierbaren Träger (1) angeordneten Behälterführung (2), welche gegenüber einem Fluidauslass (4) einer Behandlungseinheit (3) hubbeweglich verstellbar ausgebildet ist und wobei der Behälterführung (2) zumindest ein Federelement (9) zugeordnet ist, welches für eine hubbewegliche Rückstellung zwischen einer Behandlungsposition und einer Losposition eingerichtet ist,
**dadurch gekennzeichnet, dass**
zur Ausbildung einer Nothubeinrichtung (10) zumindest eine Stellkurve (12, 12a, 12b) in einem Endabschnitt an dem rotierbaren Träger (1) angeordnet ist und für die hubbewegliche Rückstellung mit der Behälterführung (2) zusammenzuwirkend in Eingriff gebracht werden kann.

2. Behälterbehandlungsanlage nach Anspruch 1, **dadurch gekennzeichnet, dass** die Behälterführung (2) zumindest einen vorstehenden Stellabschnitt (11, 11a, 11b) aufweist, welcher in dem Endabschnitt mit der zumindest einen Stellkurve (12, 12a, 12b) zusammenwirkend in Eingriff gebracht werden kann.

3. Behälterbehandlungsanlage nach Anspruch 1 oder 2, **dadurch gekennzeichnet, dass** die Behälterführung (2) als Greifer mit zumindest zwei Greiferarmen (5a, 5b) ausgebildet ist.

4. Behälterbehandlungsanlage nach Anspruch 3, **dadurch gekennzeichnet, dass** der zumindest eine Stellabschnitt (11, 11a, 11b) an einem der Greiferarme (5a, 5b) angeordnet ist und wobei die Stellkurve (12, 12a, 12b) radial außenliegend von der Behälterführung (2) angeordnet ist.

5. Behälterbehandlungsanlage nach Anspruch 4, **dadurch gekennzeichnet, dass** beide Greiferarme (5a, 5b) jeweils einen vorstehenden Stellabschnitt (11, 11a, 11b) aufweisen, wobei die Stellabschnitte (11, 11a, 11b) in dem Endabschnitt bevorzugt mit unterschiedlichen Stellkurven (12a, 12b) zusammenwirkend in Eingriff gebracht werden können.

6. Behälterbehandlungsanlage nach Anspruch 5, **dadurch gekennzeichnet, dass** die Stellkurven (12, 12a, 12b) in Transportrichtung (T) und in einer radialen Richtung (R) hintereinander angeordnet.

7. Behälterbehandlungsanlage nach Anspruch 5 oder 6, **dadurch gekennzeichnet, dass** die Stellkurven (12, 12a, 12b) und die Stellabschnitte (11, 11a, 11b) jeweils zueinander einen Versatz in vertikaler Richtung (V) aufweisen.

8. Behälterbehandlungsanlage nach Anspruch 3, **dadurch gekennzeichnet, dass** die Stellkurve (12, 12a, 12b) radial innenliegend von der Behälterführung (2) angeordnet ist und wobei der zumindest eine Stellabschnitt (11, 11a, 11b) an einer den Greifarmen (5a, 5b) gegenüberliegenden Seite der Behälterführung (2) angeordnet ist.

9. Behälterbehandlungsanlage nach einem der Ansprüche 2 bis 8, **dadurch gekennzeichnet, dass** die Stellabschnitte (11, 11a, 11b) auf einer der jeweiligen Stellkurve zugeordneten Seite eine abgerundete Anlagefläche (13) aufweisen.

10. Behälterbehandlungsanlage nach einem der vorangegangenen Ansprüche, **dadurch gekennzeichnet, dass** eine Detektionseinrichtung vorgesehen und dazu eingerichtet ist, einen Kontakt zwischen zumindest einer Stellkurve (12, 12a, 12b) und einem Stellabschnitt (11, 11a, 11b) zu detektieren.

11. Behälterbehandlungsanlage nach einem der vorangegangenen Ansprüche, **dadurch gekennzeichnet, dass** die Behandlungseinheit (14) als Beschichtungseinheit ausgebildet ist.

12. Behälterbehandlungsanlage nach einem der vorangegangenen Ansprüche, **dadurch gekennzeichnet, dass** die Behälterführung (2) oberhalb des Fluidauslasses (4) angeordnet ist.

13. Behälterbehandlungsanlage nach einem der vorangegangenen Ansprüche, **dadurch gekennzeichnet, dass** die hubbewegliche Rückstellung zwischen der Behandlungsposition und einer Losposition entlang einer Länge zwischen 5 mm und 20 mm ausgebildet ist.

14. Behälterbehandlungsanlage nach einem der vorangegangenen Ansprüche mit einer Vielzahl von in Umfangsrichtung identisch ausgebildeten Behälterführungen (2), welche zumindest einer gemeinsamen Stellkurve (12, 12a, 12b) zugeordnet sind.
